# EUROPÄISCHE PATENTSCHRIFT

(11) **EP 0 597 254 B1**
(45) Veröffentlichungstag und Bekanntmachung des Hinweises auf die Patenterteilung: **07.05.1997**
(21) Anmeldenummer: 93116284.6
(22) Anmeldetag: 08.10.1993
(51) Int. Cl.: H01L 25/16, H01L 23/48

(54) **Schaltungsanordnung für Leistungshalbleiterbauelemente**
Device with power semiconductor components
Dispositif avec composants semi-conducteurs de puissance

(30) Priorität: 07.11.1992 DE 4237632
(43) Veröffentlichungstag der Anmeldung: 18.05.1994
(73) Patentinhaber: EXPORT-CONTOR Aussenhandelsgesellschaft mbH, D-90253 Nürnberg (DE)
(72) Erfinder:

(56) Entgegenhaltungen:
- WO-A-91/00619
- WO-A-92/16091
- US-A- 4 965 710

## Beschreibung

Die Erfindung betrifft eine Schaltungsanordnung mit einem Kühlbauteil, mit mindestens einer Trägerplatte, die auf dem Kühlbauteil angeordnet ist und an der Kontaktflächen und zu kühlende Bauelemente vorgesehen sind, und mit einer zum Drücken der/jeder Trägerplatte gegen das Kühlbauteil vorgesehenen Andrückvorrichtung, die ein formstabiles Montageelement, ein formstabiles Brückenelement und zwischen dem Montageelement und dem Brückenelement ein nachgiebiges Kissenelement aufweist.

Aus der DE-A 4 111 247 der Anmelderin ist eine Schaltungsanordnung mit einem Kühlbauteil, mit mindestens einer Trägerplatte, die auf dem Kühlbauteil angeordnet ist und an der Kontaktflächen und zu kühlende Bauelemente vorgesehen sind, und mit einer zum Drücken der/jeder Trägerplatte gegen das Kühlbauteil vorgesehenen Andrückvorrichtung bekannt. Bei dieser bekannten Schaltungsanordnung weist die Andrückvorrichtung mindestens ein Montageelement und ein nachgiebiges Kissenelement auf, das auf der dem Kühlbauteil zugewandten Innenseite des Montageelementes vorgesehen ist.

In der Zusatzpatentanmeldung P 41 22 428 der Anmelderin ist eine Schaltungsanordnung der eingangs genannten Art beschrieben, bei der die Andrückvorrichtung ein formstabiles Montageelement, ein formstabiles Brückenelement und zwischen diesen Elementen ein nachgiebiges Kissenelement aufweist.

Sowohl bei der Schaltungsanordnung gemäß DE-A 4 111 247 als auch bei der zuletzt genannten Schaltungsanordnung sind die Trägerplatten zwischen dem Kühlbauteil und der Andrückvorrichtung derartig unzugänglich vorgesehen, daß die Modifizierbarkeit der Schaltungsanordnung insgesamt beeinträchtigt sein kann. Das gilt bspw. auch für die Schaltungsanordnung, wie sie aus der DE-A 35 08 456 oder aus der DE-A 35 21 572 bekannt sind.

Aus der DE-C 36 28 556 ist eine Halbleiteranordnung bekannt, bei der wenigstens eine Halbleitertablette mit Stromleiterteilen auf einer Grundplatte angebracht und in Isolierstoffmasse eingekapselt ist. Dort sind Stromleiterteile wenigstens stellenweise als Kontaktstücke zur Druckkontaktierung ausgebildet. Diese Kontaktstücke ragen auf der von der Grundplatte abgewandten Seite der Halbleitertablette aus der Isolierstoffmasse heraus. Die Kontaktstücke sind außerhalb der Isolierstoffkapselung druckkontaktiert, wobei eine allen Kontaktstücken gemeinsame Kontaktplatte vorgesehen ist. Durch die Kapselung in der erwähnten Isolierstoffmasse ist auch bei dieser bekannten Halbleiteranordnung die Modifizierbarkeit eingeschränkt.

Eine Halbleiterbaueinheit in Hybrid-Struktur ist in der DE-A 3 643 288 beschrieben. Diese Halbleiterbaueinheit soll einen hohen Integrationsgrad, die elektrische Vorprüfung aller Komponenten vor der Montage und eine einfache Befestigung und Kontaktierung mit Trägerbauteilen ermöglichen.

Der Erfindung liegt die Aufgabe zugrunde, eine Schaltungsanordnung der eingangs genannten Art zu schaffen, bei welcher die Modifizierbarkeit, d.h. die Anpassung der Schaltungsanordnung an die jeweils gegebenen physikalischen bzw. elektrischen Anforderungen bzw. Gegebenheiten verbessert ist, wobei gleichzeitig ein hoher Integrationsgrad sowie eine elektrische Vorprüfung aller Komponenten der Schaltungsanordnung vor deren Zusammenbau sowie eine einfache Befestigung und Kontaktierung derselben möglich ist.

Diese Aufgabe wird bei einer Schaltungsanordnung gemäß dem Anspruch 1 dadurch gelöst, daß an der Andrückvorrichtung mindestens ein elektrisch isolierendes Substrat vorgesehen ist, das von der/jeder Trägerplatte beabstandet und zur mindestens einen Trägerplatte parallel vorgesehen ist und das mit einer Schaltstruktur und gegebenenfalls mit Bauelementen versehen ist, und daß die Schaltungsstruktur des mindestens einen Substrates mit zugehörigen Kontaktflächen der mindestens einen Trägerplatte mittels federnd nachgiebiger Kontaktelemente elektrisch leitend verbunden ist, die durch die Andrückvorrichtung positioniert sind. Bei der erfindungsgemäßen Schaltungsanordnung ist das mindestens eine elektrisch isolierende Substrat also in einer Ebene vorgesehen, die von der Ebene der mindestens einen Trägerplatte verschieden ist. Dadurch ist es einfach möglich, sowohl die besagte mindestens eine Trägerplatte mit den entsprechenden elektrischen bzw. elektronischen Bauelementen zu bestücken, als auch das mindestens eine elektrisch isolierende Substrat gegebenenfalls mit zugehörigen Bauelementen zu bestücken, wobei das besagte mindestens eine elektrisch isolierende Substrat derartig mit einer Schaltstruktur ausgebildet ist, daß mit Hilfe der federnd nachgiebigen Kontaktelemente zwischen dem/jedem Substrat und der bzw. der entsprechenden Trägerplatte die gewünschten elektrisch leitenden Verbindungen hergestellt werden. Die Kontaktelemente werden erfindungsgemäß durch die Andrückvorrichtung genau passend positioniert, was bedeutet, daß die Andrückvorrichtung nicht nur dazu vorgesehen ist, die/jede Trägerplatte gegen das Kühlbauteil zu drücken, um von der entsprechenden Trägerplatte die Verlustwärme optimal abzuführen, sondern daß die Andrückvorrichtung in vorteilhafter Weise gleichzeitig auch zur passenden Positionierung der entsprechenden federnd nachgiebigen Kontaktelemente vorgesehen ist. Die besagten Kontaktelemente können in vorteilhafter Weise gleichzeitig auch zum Positionieren und Fixieren der Trägerplatten und des mindestens einen Substrats dienen. Die gegenseitige Justierung kann hierbei derart genau sein, daß das mindestens eine Substrat auch Chips aufweisen kann, die mittels zugehöriger Kontaktelemente direkt kontaktiert werden können. Eine derartig ausgebildete Schaltungsanordnung weist also die Vorteile auf, daß ein hoher Integrationsgrad erreichbar ist, daß eine elektrische Vorprüfung aller Komponenten vor der Montage der Schaltungsanordnung möglich ist, daß eine einfache Befestigung der Komponenten in bezug zueinander möglich ist, daß auf einfache Weise eine zuverlässige und mechanisch genaue Kontaktierung der entsprechenden Bauelemente miteinander bzw. mit den zugehörigen Schaltungsstrukturen möglich ist, und daß auch die gegebenenfalls erforderliche Demontage und der Ersatz schadhafter Komponenten durch ungebrauchte neue Komponenten auf einfache Weise möglich ist.

Bei der erfindungsgemäßen Schaltungsanordnung kann das mindestens eine Substrat zwischen dem elektrisch isolierenden Brückenelement und dem elektrisch isolierenden Kissenelement der Andrückvorrichtung vorgesehen sein, wobei die federnden Kontaktelemente durch das Brückenelement genau passend positioniert sein können. Bei einer solchen Ausbildung der Schaltungsanordnung ist das mindestens eine Substrat also durch das Brücken- bzw. Kissenelement genau richtig positioniert. Die passende Positionierung der Kontaktelemente zwischen Substrat und Trägerplatte erfolgt hierbei durch das Brückenelement.

Eine andere Möglichkeit besteht darin, daß bei der erfindungsgemäßen Schaltungsanordnung das mindestens eine Substrat zwischen dem elektrisch isolierenden Kissenelement und dem elektrisch isolierenden Montageelement der Andrückvorrichtung vorgesehen ist, und daß die federnden Kontaktelemente durch das elektrisch isolierende Brückenelement und/oder durch das Kissenelement genau passend positioniert sind. Bei einer derartigen Ausbildung der Schaltungsanordnung ist das mindestens eine Substrat also durch das Kissen- bzw. Montageelement genau richtig positioniert. Die federnden Kontaktelemente zur Verbindung des entsprechenden Substrates mit der zugehörigen Trägerplatte können hierbei durch das elektrisch isolierende Brückenelement oder durch das elektrisch isolierende Kissenelement allein genau passend positioniert sein; es ist jedoch auch möglich, daß die besagten Kontaktelemente durch das Brücken- und das Kissenelement passend positioniert sind.

Während bei den zuletzt genannten Schaltungsanordnungen das mindestens eine Substrat innerhalb der Andrückvorrichtung vorgesehen ist, so daß die Bestückung des mindestens einen Substrates mit zugehörigen elektrischen bzw. elektronischen Bauelementen gewissen Einschränkungen unterliegen kann, ist es zur Eliminierung dieser Einschränkungen auch möglich, daß das mindestens eine Substrat auf der vom Kühlbauteil abgewandten Seite des elektrisch isolierenden Montageelementes der Andrückvorrichtung vorgesehen ist, und daß die federnden Kontaktelemente durch das elektrisch isolierende Brückenelement und/oder das elektrisch isolierende Kissenelement und/oder das Montageelement positioniert sind. Eine derartige Ausbildung der Schaltungsanordnung weist den Vorteil auf, daß das mindestens eine Substrat an der Außenseite der Schaltungsanordnung und somit gut zugänglich vorgesehen ist, so daß das Substrat problemlos mit zugehörigen elektrischen und/oder elektronischen Bauelementen bestückt sein kann, ohne daß dies zu einer Beeinträchtigung der Schaltungsanordnung führt.

Bei einer Schaltungsanordnung der zuletzt genannten Art hat es sich als zweckmäßig erwiesen, wenn das mindestens eine Substrat vom Montageelement durch Distanzelemente beabstandet ist. Diese Distanzelemente können als vom Montageelement unabhängige Teile ausgebildet sein, es ist jedoch auch möglich, die Distanzelemente an das Montageelement einstückig anzuformen.

Als besonders zweckmäßig hat es sich erwiesen, wenn bei der erfindungsgemäßen Schaltungsanordnung mindestens zwei Trägerplatten vorgesehen sind, die unmittelbar übereinander angeordnet sind, die seitlich gegeneinander versetzt sind und die mittels deckungsgleich vorgesehener Kontaktorgane miteinander kontaktiert sind, und wenn das Kühlbauteil mit einer abgestuften Aufnahmefläche und die Andrückvorrichtung mit einer abgestuften Andrück-Grundfläche ausgebildet sind zum Festlegen der Trägerplatten aneinander und zwischen dem Kühlbauteil und der Andrückvorrichtung. Mittels der Andrückvorrichtung ist es in vorteilhafter Weise möglich, die Trägerplatten genau zu positionieren. Für eine derartige Schaltungsanordnung wird ein selbständiger Patentschutz beantragt, sie ist sehr einfach ausgebildet und problemlos und zeitsparend montierbar bzw. im Bedarfsfall demontierbar, um Bauteile durch ungebrauchte neue Bauteile ersetzen zu können.

Zweckmäßig ist es bei einer solchen Schaltungsanordnung, wenn das Kühlbauteil mit mindestens einem Aufnahmeraum für diskrete Bauelemente ausgebildet ist, die an der entsprechenden Trägerplatte vorgesehen sind. Bei diesen diskreten Bauelementen kann es sich bspw. um Leistungskondensatoren, um elektrische Spulen oder um Stromsensoren handeln. Die Ausbildung der Schaltungsanordnung mit einem Kühlbauteil der zuletzt genannten Art, d.h. mit einem Kühlbauteil mit mindestens einem Aufnahmeraum für die besagten diskreten Bauelemente weist außerdem den Vorteil auf, daß von den zuletzt erwähnten diskreten Bauelementen die Verlustwärme optimal abgeführt werden kann, wobei sich der weitere Vorteil einer vergleichsweise raumsparenden Ausbildung der Schaltungsanordnung ergibt. Denselben Zwecken ist es dienlich, wenn bei der erfindungsgemäßen Schaltungsanordnung die mindestens eine Trägerplatte insbes. für Leistungskomponenten einer Stromrichter-Schaltungsanordnung und wenn das mindestens eine Substrat insbes. für elektrische bzw. elektronische Steuerungskomponenten der entsprechenden Leistungskomponenten der Stromrichter-Schaltungsanordnung vorgesehen ist, weil dann die Verlustwärme von den Leistungskomponenten optimal an das Kühlbauteil abgeleitet werden kann, wobei die Steuerungskomponenten der entsprechenden Leistungskomponenten in vorteilhafter Weise gut zugänglich sind, so daß Modifikationen der Schaltungsanordnung wunschgemäß in einfacher Weise möglich sind.

Weitere Einzelheiten, Merkmale und Vorteile ergeben sich aus der nachfolgenden Beschreibung zweier Ausführungsbeispiele der erfindungsgemäßen Schaltungsanordnung, wobei es sich versteht, daß die Erfindung nicht auf die in der Zeichnung dargestellten Ausbildungen der Schaltungsanordnung beschränkt ist. Es zeigen:
- Fig. 1: einen Schnitt durch eine erste Ausbildung der Schaltungsanordnung, wobei das Kühlbauteil nur abschnittweise gezeichnet ist, und
- Fig. 2: eine zweite Ausführungsform der Schaltungsanordnung, bei welcher sowohl das Kühlbauteil als auch die beiden Substrate der Schaltungsanordnung abschnittweise gezeichnet sind.

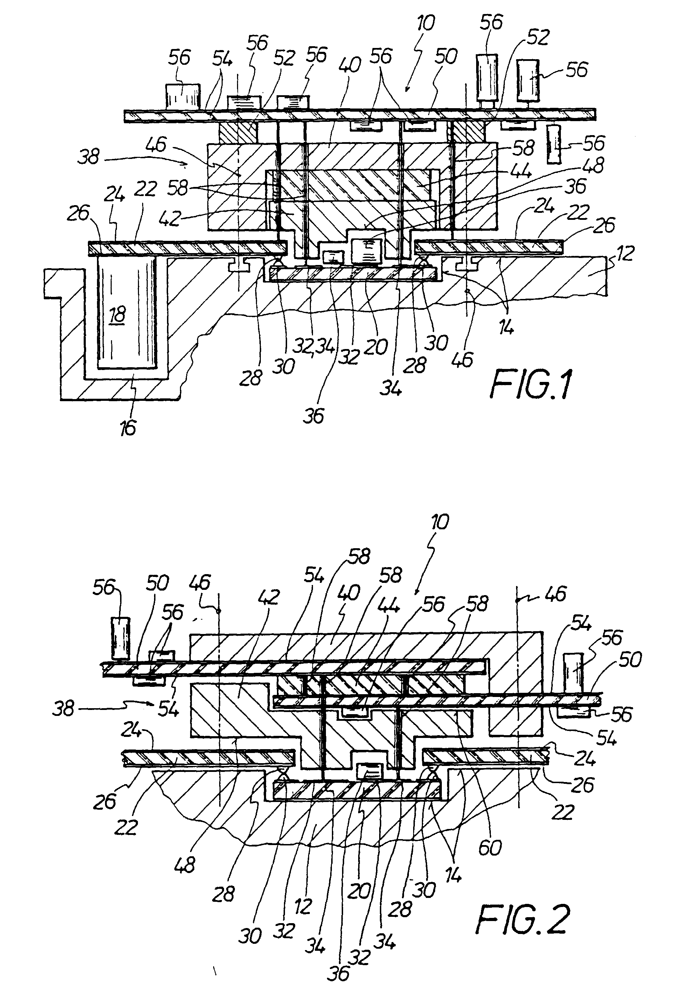

Fig. 1 zeigt eine Ausführungsform der Schaltungsanordnung 10 mit einem Kühlbauteil 12, das mit einer abgestuften Aufnahmefläche 14 und somit mit einem Aufnahmeraum 16 für diskrete Bauelemente 18 ausgebildet ist, wobei die abgestufte Aufnahmefläche 14 zur positionierten Aufnahme einer Trägerplatte 20 und einer Trägerplatte 22 vorgesehen ist. Die Trägerplatte 22 weist Leiterbahnen 24 und 26 auf, mit welchen die oben erwähnten Bauelemente 18 elektrisch leitend verbunden sind. Die abgestufte Aufnahmefläche 14 des Kühlbauteils 12 ist derartig ausgebildet bzw. vorgesehen, daß die Trägerplatten 20 und 22 passend übereinander angeordnet und seitlich gegeneinander derart versetzt sind, daß sie mittels deckungsgleich vorgesehener Kontaktorgane 28 der Trägerplatte 22 und Kontaktorgane 30 der Trägerplatte 20 miteinander geeignet kontaktiert sind. Die Trägerplatte 20 ist mit Leiterbahnen 32 bzw. Kontaktflächen 34 ausgebildet und mit zu kühlenden Bauelementen 36 versehen. Bei diesen Bauelementen 36 kann es sich bspw. um ungehäuste Chipelemente handeln.

Die Schaltungsanordnung 10 weist außerdem eine Andrückvorrichtung 38 mit einem formstabilen Montageelement 40 und einem formstabilen Brückenelement 42 auf, zwischen welchen ein nachgiebiges Kissenelement 44 vorgesehen ist. Das Montageelement 40 und das Brückenelement 42 können aus geeigneten Kunststoffmaterialien bestehen. Das Kissenelement 44 besteht zweckmäßigerweise aus einem geeigneten Gummimaterial. Die Andrückvorrichtung 38 ist mittels Befestigungselementen am Kühlbauteil 12 befestigt und genau justiert. Von den zuletzt genannten Befestigungselementen sind in Fig. 1 nur die Mittellinien 46 mit strichpunktierten Linien gezeichnet.

Aus Fig. 1 ist außerdem ersichtlich, daß die Andrückvorrichtung 38 bzw. ihr Brückenelement 42 mit einer abgestuften Andrück-Grundfläche 48 ausgebildet ist, die zum Festlegen der Trägerplatten 20, 22 aneinander und zwischen dem Kühlbauteil 12 und der Andrückvorrichtung 38 dient. Außerdem kann die abgestufte Andrück-Grundfläche 48 mit Aussparungen zur Aufnahme, Positionierung und/oder Kontaktierung der Bauelemente 36 an der Trägerplatte 20 bzw. von (nicht gezeichneten) Bauelementen an der Trägerplatte 22 dienen.

An der Andrückvorrichtung 38 ist in Fig. 1 ein elektrisch isolierendes Substrat 50 angeordnet, das von der Andrückvorrichtung 38 durch Distanzelemente 52 beabstandet ist. Bei der in Fig. 1 gezeichneten Ausbildung der Schaltungsanordnung 10 befindet sich das Substrat 50 auf der vom Kühlbauteil 12 abgewandten Außenseite der Andrückvorrichtung 38 und ist von außerhalb der Schaltungsanordnung 10 problemlos zugänglich. Am Substrat 50 ist eine Schaltungsstruktur 54 und sind mit der Schaltungsstruktur 54 kontaktierte Bauelemente 56 vorgesehen. Die am Substrat 50 ausgebildete Schaltungsstruktur 54 ist mit zugehörigen Kontaktflächen 34 der Trägerplatte 20 bzw. mit Kontaktflächen der Leiterbahnen 24 der Trägerplatte 22 mittels federnd nachgiebiger Kontaktelemente 58 elektrisch leitend verbunden. Die Kontaktelemente 58 sind bspw. als Nadeln mit einer federnden Schleife, als abgewinkelte Nadeln, als Nadeln mit einem Schraubgewindeabschnitt oder beliebig anders ausgebildet, wobei es nur darauf ankommt, daß die Kontaktelemente 58 durch die Andrückvorrichtung 38 gehalten und justiert werden und zwischen dem Substrat 50 und der entsprechenden Trägerplatte 20, 22 federnd vorgesehen sind und einen elektrisch leitenden Kontakt herstellen. Die Kontaktelemente 58 erstrecken sich durch die Andrückvorrichtung 38 derartig hindurch, daß mittels der Andrückvorrichtung 38 eine genaue Positionierung der federnden Kontaktelemente 58 bewirkt wird.

In Fig. 2 ist abschnittweise in einer Schnittdarstellung eine Ausbildung der Schaltungsanordnung 10 angedeutet, die sich von der in Fig. 1 gezeichneten Ausbildung der Schaltungsanordnung 10 insbes. dadurch unterscheidet, daß nicht nur ein Substrat 50 vorgesehen ist, sondern daß zwei Substrate 50 vorhanden sind, von denen das eine Substrat 50 zwischen dem formstabilen Montageelement 40 und dem nachgiebigen Kissenelement 44 und das zweite Substrat 50 zwischen dem Kissenelement 44 und dem formstabilen Brückenelement 42 vorgesehen ist. Bei einer solchen Ausbildung der Schaltungsanordnung 10 können Kontaktelemente 58 zur elektrisch leitenden Verbindung zwischen dem einen oder anderen Substrat 50 mit der Trägerplatte 20 bzw. der Trägerplatte 22 oder zur elektrisch leitenden Verbindung zwischen den Substraten 50 vorgesehen sein. Bei der in Fig. 2 gezeichneten Ausbildung der Schaltungsanordnung 10 ist das formstabile Brückenelement 42 nicht nur auf seiner dem Kühlbauteil 12 zugewandten Seite mit einer abgestuften Andruck-Grundfläche 48 ausgebildet, sondern auch mit einer abgestuften Oberfläche 60, durch welche Aussparungen gebildet werden, die zur Aufnahme entsprechender Bauelemente 56 des Substrats 50 zwischen Brückenelement 42 und Kissenelement 44 vorgesehen sind.

Gleiche Einzelheiten sind in Fig. 2 mit denselben Bezugsziffern bezeichnet wie in Fig. 1, so daß es sich in Verbindung mit Fig.2 erübrigt, alle diese Einzelheiten noch einmal detailliert zu beschreiben.

In den Figuren ist das/jedes Substrat 50 mit sich gegenüberliegenden Schaltungsstrukturen 54, d.h. Leiterbahnen und Bauelementen 56 dargestellt. Die sich gegenüberliegenden Schaltungsstrukturen 54 können durch (nicht gezeichnete) Verbindungselemente geeignet zusammengeschaltet sein.

## Patentansprüche

1. Schaltungsanordnung für Leistungshalbleiterbauelemente mit hoher Packungsdichte mit einem Kühlbauteil (12), mit mindestens einem elektrisch isolierenden Substrat (50), aufweist, mit mindestens einer Trägerplatte(20, 22), die auf dem Kühlbauteil (12) angeordnet ist und an der Kontaktflächen (34) und zu kühlende Bauelemente (36) vorgesehen sind, und mit einer zum Drücken der/jeder Trägerplatte (20, 22) gegen das Kühlbauteil (12) vorgesehenen Andrückvorrichtung (38), die ein formstabiles Montageelement (40), ein formstabiles Brückenelement (42) und zwischen dem Montageelement (40) und dem Brückenelement (42) ein nachgiebiges Kissenelement (44) **dadurch gekennzeichnet, daß**
das mindestens eine, gegebenenfalls mit Bauelementen (56) versehene, Substrat (50) zu der mindestens einen in den Trägerplatte (20, 22), die mit strukturierten elektrischen Leiterbahnen versehen ist, parallel angeordnet ist und daß eine Schaltungsstruktur (54) des mindestens einen Substrates(50) mit zugehörigen Kontaktflächen (34) der mindestens einen Trägerplatte (20, 22) mittels federnd nachgiebiger Kontaktelemente (58), die durch die Andrückvorrichtung (38) positioniert sind, elektrisch leitend verbunden ist.

2. Schaltungsanordnung nach Anspruch 1,
**dadurch gekennzeichnet, daß**
das mindestens eine Substrat (50) zwischen dem Brückenelement (42) und dem Kissenelement (44) der Andrückvorrichtung (38) vorgesehen ist, und das die federnden Kontaktelemente (58) durch das Brückenelement (42) genau passend positioniert sind.

3. Schaltungsanordnung nach Anspruch 1,
**dadurch gekennzeichnet, daß** das mindestens eine Substrat (50) zwischen dem Kissenelement (44) und dem Montageelement (40) der Andrückvorrichtung (38) vorgesehen ist und daß die federnden Kontaktelemente (58) durch das elektrisch isolierende Brückenelement (42) und/oder durch das Kissenelement (44) genau passend positioniert sind.

4. Schaltungsanordnung nach Anspruch 1,
**dadurch gekennzeichnet, daß**
das mindestens eine Substrat (50) auf der vom Kühlbauteil (12) abgewandten Seite des Montageelementes (40) der Andrückvorrichtung (38) vorgesehen ist, und daß die federnden Kontaktelemente (58) durch das Brückenelement (42) und/oder das Kissenelement (44) und/oder das Montageelement (40) genau passend positioniert sind.

5. Schaltungsanordnung nach Anspruch 1, dadurch gekennzeichnet, daß mindestens zwei Trägerplatten (20, 22) vorgesehen sind, die übereinander angeordnet sind, die seitlich gegeneinander versetzt sind, und die mittels deckungsgleich vorgesehener Kontaktorgane (28, 30) miteinander kontaktiert sind, und daß das Kühlbauteil (12) mit einer abgestuften Aufnahmefläche (14) und die Andrückvorrichtung mit einer abgestuften Andrückgrundfläche (48), zum Festlegen der Trägerplatten (20,22) aneinander und zwischen dem Kühlbauteil (12) und der Andrückvorrichtung (38), ausgebildet sind.

## Claims

1. A circuit arrangement with power semiconductor components with a high packing density, comprising a cooling component (12), at least one electrically insulating substrate (50), at least one carrier plate (20, 22) disposed on said cooling component (12) and on which contact faces (34) and components (36) to be cooled are provided, and a pressing apparatus (38) provided for pressing said/each carrier plate (20, 22) against said cooling component (12) and having a dimensionally rigid assembly element (40), a dimensionally rigid bridge element (42) and an elastic cushioning element (44) between said assembly element (40) and said bridge element (42),
**characterized in that**
said at least one substrate (50) possibly provided with components (56) is disposed parallel to said at least one carrier plate (20, 22) fitted with structured electrical conductor paths, and that a circuit structure (54) of said at least one substrate (50) is connected in an electrically conducting manner to associated contact faces (34) of said at least one carrier plate (20, 22) by means of resiliently elastic contact elements (58) positioned by said pressing apparatus (38).

2. A circuit arrangement according to claim 1
**characterized in that**
said at least one substrate (50) is provided between said bridge element (42) and said cushioning element (44) of said pressing apparatus (38), and that said resilient contact elements (58) are positioned by said bridge element (42) to match exactly.

3. A circuit arrangement according to claim 1,
**characterized in that**
said at least one substrate (50) is provided between said cushioning element (44) and said assembly element (40) of said pressing apparatus (38), and that said resilient contact elements (58) are positioned by said electrically insulating bridge element (42) and/or by said cushioning element (44) to match exactly.

4. A circuit arrangement according to claim 1,
**characterized in that**
said at least one substrate (50) is provided on that side of said assembly element (40) of said pressing apparatus (38) facing away from said cooling component (12), and that said resilient contact elements (58) are positioned by said bridge element (42) and/or said cushioning element (44) and/or said assembly element (40) to match exactly.

5. A circuit arrangement according to claim 1, characterized in that at least two carrier plates (20, 22) are provided which are disposed above one another, laterally offset against one another and contacted together by means of congruently provided contact elements (28, 30), and that said cooling component (12) has a graduated receiving face (14) and said pressing apparatus has a graduated pressing base face (48) to secure said carrier plates (20, 22) to one another and between said cooling component (12) and said pressing apparatus (38).

## Revendications

1. Dispositif de connexion pour composants à semi-conducteurs de puissance, à densité d'encapsulation élevée, avec un élément de refroidissement (12), avec au moins un substrat (50) isolant de l'électricité, avec au moins une plaque-support (20, 22) disposée sur l'élément de refroidissement (12) et sur laquelle des surfaces de contact (34) et des composants (36) à refroidir sont prévus, et avec un dispositif de pressage (38), prévu pour presser la/chaque plaque-support (20, 22) contre l'élément de refroidissement (12), présentant un élément de montage (40) à stabilité de forme, un élément pont (42) à stabilité de forme et un élément coussin (44) déformable, entre l'élément de montage (40) et l'élément pont (42),
caractérisé en ce qu'
au moins un substrat (50), pourvu le cas échéant de composants (56), est disposé parallèlement à la au moins une plaque-support (20, 22), pourvue de pistes conductrices de l'électricité structurées, et en ce qu'une structure de circuit (56) du au moins un substrat (50) est reliée, de façon conductrice de l'électricité, à des surfaces de contact (34) afférentes de la au moins une plaque-support (20, 22), au moyen d'éléments de contact (58) déformables élastiquement, positionnés par le dispositif de pressage (38).

2. Dispositif de connexion selon la revendication 1, caractérisé en ce que le au moins un substrat (50) est prévu entre l'élément pont (42) et l'élément coussin (44) du dispositif de pressage (38), et en ce que les éléments de contact (58) élastiques sont positionnés de façon ajustée précisément par l'élément pont (52).

3. Dispositif de connexion selon la revendication 1, caractérisé en ce que le au moins un substrat (50) est prévu entre l'élément coussin (44) et l'élément de montage (40) du dispositif de pressage (38), et en ce que les éléments de 5 contact (58) élastiques sont positionnés de façon ajustée précisément par l'élément pont (42) isolant de l'électricité et/ou par l'élément coussin (44).

4. Dispositif de connexion selon la revendication 1, caractérisé en ce que le au moins un substrat (50) est prévu sur la face, opposée à l'élément de refroidissement (12), de l'élément de montage (40) du dispositif de pressage (38), et en ce que les éléments de contact (58) élastiques sont positionnés de façon ajustée avec précision par l'élément pont (42) et/ou l'élément coussin (44) et/ou l'élément de montage (40).

5. Dispositif de connexion selon la revendication 1, caractérisé en ce que au moins deux plaques-support (20, 22) sont prévues, disposées l'une au-dessus de l'autre, décalées latéralement l'une par rapport à l'autre et mises en contact ensemble au moyen d'organes de contact (28, 30) prévus en coïncidence et en ce que l'élément de refroidissement (12) est réalisé avec une surface de support (14) étagée et le dispositif de pressage est réalisé avec une surface de base de pressage (48) étagée, pour assurer la fixation des plaques-support (20, 22) l'une sur l'autre et entre l'élément de refroidissement (12) et le dispositif de pressage (38).
